# EUROPÄISCHE PATENTSCHRIFT

(11) **EP 1 158 838 B1**
(45) Veröffentlichungstag und Bekanntmachung des Hinweises auf die Patenterteilung: **26.11.2008**
(21) Anmeldenummer: 01112196.9
(22) Anmeldetag: 18.05.2001
(51) Int. Cl.: H05B 3/74, F24C 7/08

(54) **Berührungsschalteinrichtung**
Touch-controlled switching device
Dispositif de commutation commandé par effleurement

(30) Priorität: 25.05.2000 DE 10026058
(43) Veröffentlichungstag der Anmeldung: 28.11.2001
(73) Patentinhaber: E.G.O. ELEKTRO-GERÄTEBAU GmbH, 75038 Oberderdingen (DE)
(72) Erfinder: Supper, Bernd, 71665 Vaihingen/Enz (DE)
(74) Vertreter: Patentanwälte Ruff, Wilhelm, Beier, Dauster & Partner

(56) Entgegenhaltungen:
- US-A- 4 121 204

## Beschreibung

Die Erfindung betrifft eine Berührungsschalteinrichtung.

Eine gattungsgemäß zugrunde gelegte Berührungsschalteinrichtung geht beispielsweise aus der EP 0 443 924 A1 als bekannt hervor. Bei einer derartigen Berührungsschalteinrichtung, wie sie insbesondere auch für Küchengeräte wie Herde, Backöfen und dergleichen benutzt werden kann, ist ein Schaltfeld vorgesehen. Innerhalb dieses Schaltfeldes ist wenigstens eine Schaltfläche ausgebildet. Durch Betätigung der Schaltfläche, nämlich durch Berühren, wird eine Schaltfunktion veranlaßt, für deren Durchführung eine Steuereinrichtung vorgesehen ist.

Derartige Schalteinrichtungen haben den Vorteil, daß sie beispielsweise unterhalb von geschlossenen Oberflächen - wie einer Glaskeramikkochplatte - anbringbar sind und somit beispielsweise gut vor Feuchtigkeit und anderen externen Einflüssen geschützt werden können.

Ein Nachteil derartiger Berührungsschalteinrichtungen ist es, daß mit Ausbildung der Berührungsschaltflächen auch festgelegt wird, wie die Anordnung der Schaltelemente zueinander ist, wie die geometrische Lage und Form der einzelnen Schaltelemente ausgebildet ist und welche Schaltelemente vorhanden sind.

Diese Nachteile fallen besonders dann ins Gewicht, wenn im Interesse der Erhöhung der Anzahl von Gleichteilen ein und dieselbe Schalteinrichtung für eine Vielzahl von Modellen eines Herstellers verwendet werden soll, bei denen Unterschiede beispielsweise im Design und in der Anzahl der erforderlichen Schaltelemente vorhanden sind.

Die US-PS 4121204 zeigt eine weitere gattungsgemäße Berührungsschalteinrichtung, bei der mehrere Schaltflächen einer optischen Balkenanzeige zugeordnet sind. Die Balkenanzeige besteht aus Leuchtsegmenten, denen jeweils eine Schaltfläche mit einem Sensor zugeordnet ist. Durch direktes Berühren eines einzigen Sensors unter einer Schaltfläche kann ein Bediener einen Parameter, der mittels der Berührungsschalteinrichtung gesteuert werden soll, verstellen. Nach dem Verstellen erhält er eine visuelle Rückmeldung dadurch, dass die Balkenanzeige einen Balken anzeigt, der von einem Ende der Balkenanzeige bis zu der berührten Schaltfläche reicht und dessen Länge den Wert des eingestellten Parameters repräsentiert.

Aufgabe der Erfindung ist es, eine Berührungsschalteinrichtung zu schaffen, bei der eine größtmögliche Anzahl von Gleichteilen auch bei unterschiedlicher Anzahl und Ausbildung von Schaltflächen möglich ist.

Diese Aufgabe wird bei Zugrundelegen der gattungsgemäß ausgebildeten Berührungsschalteinrichtung erfindungsgemäß durch die kennzeichnenden Merkmale des Anspruchs 1 gelöst.

Eine Berührungsschalteinrichtung, wie sie insbesondere für Küchengeräte wie Herde, Backöfen, Kühlschränke, Tiefkühltruhen und dergleichen verwendbar ist, weist ein Schaltfeld auf. Innerhalb dieses Schaltfeldes ist wenigstens eine Schaltfläche ausgebildet. In einer Steuereinrichtung findet eine Zuordnung zwischen Schaltfläche und bei Betätigung der Schaltfläche auszuführender Schaltfunktion statt. Hierzu ist wenigstens ein Sensor vorgesehen, der die Betätigung der wenigstens einen Schaltfläche aufgrund einer Veränderung des Sensorsignals erfaßt. Dabei findet eine charakteristische Veränderung des Sensorsignals dann statt, wenn das Schaltfeld im Bereich der Schaltfläche berührt wird, wobei es erforderlich sein kann, daß eine Mindestanlagekraft im Bereich des Schaltfeldes auf dieses einwirkt. Erfindungsgemäß werden in der Steuereinrichtung die Sensorsignale mehrerer Sensoren ausgewertet. Dabei wird aus den Sensorsignalen die Position des Betätigungsortes innerhalb des Schaltfeldes ermittelt. In der Steuereinrichtung ist eine Zuordnungsfunktion vorhanden, wobei Positionen des Schaltfeldes einer Schaltfläche zugeordnet werden. Aufgrund dieser Zuordnungsfunktion wird ermittelt, welcher Schaltfläche der Position des Betätigungsortes der aktuellen Betätigung zuzuordnen ist. Aufgrund der Zuordnungsfunktion wurde somit eine zugehörige Schaltfläche ermittelt und anschließend wird die Schaltfunktion, die dieser Schaltfläche zugeordnet ist, durchgeführt.

Wird eine derartige Berührungsschalteinrichtung beispielsweise für das Kochfeld eines Herdes verwendet, so wird für jede Heizstelle des Kochfeldes wenigstens ein Schaltelement vorgesehen, das die Regelung der Leistung vornimmt. Bestimmte Positionen des Schaltfeldes werden einer Schaltfläche zugeordnet. Diese Schaltfläche wiederum ist einer Kochstelle zugeordnet. Über eine Betätigung der Schaltfläche kann nun die Leistungsaufnahme der zugeordneten Kochstelle vergrößert, verkleinert oder auf Null abgesenkt werden. Es findet also eine doppelte Zuordnung statt. Zum einen wird eine Position des Schaltfeldes einer bestimmten Schaltfläche zugeordnet. Zum anderen wird der Schaltfläche eine bestimmte Schaltfunktion, beispielsweise Erhöhen Leistung an "Kochstelle vorne links" zugeordnet.

Gemäß einer bevorzugten Ausführung der Erfindung ist die Anzahl der Sensoren des Schaltfeldes derart gewählt, daß eine eindeutige Bestimmung der Position der Betätigung des Schaltfeldes möglich ist. Gemäß Weiterführen dieser Ausgestaltung beträgt die Anzahl der Sensoren wenigstens drei und vorzugsweise höchstens sechs. Ist ein Schaltfeld so ausgebildet, daß zwischen jedem Punkt des Schaltfeldes und jedem im Schaltfeld angeordneten Sensor eine lineare Verbindungslinie gezogen werden kann, die über ihre ganze Länge hinweg innerhalb des Schaltfeldes liegt, so genügen drei Sensoren zur Bestimmung der Position der Betätigung des Schaltfeldes. Dabei ist es nur erforderlich, daß über jeden Sensor der Abstand zwischen Betätigungsort und Sensor erfaßt wird, das Sensorsignal also eine charakteristische Abhängigkeit zu diesem Abstand aufweist. Durch die Bestimmung des Abstandes der Position der Betätigung zu drei an voneinander unterschiedlichen Orten angeordneten Sensoren ist es durch einfache Triangularisation möglich, den genauen Ort der Betätigung zu bestimmen. Im Sinne einer Erhöhung der Meßgenauigkeit ist es möglich, mehr als drei Sensoren, beispielsweise vier oder fünf Sensoren, vorzusehen. Durch die Erhöhung der Anzahl von Sensoren ist es auch möglich, die Flexibilität der Gestaltung des Schaltfeldes zu ermöglichen. So ist es möglich, Schaltfelder zu schaffen, bei denen es Positionen gibt, die nicht in direkter linearer Verbindung zu allen Sensoren stehen, sofern diese direkte lineare Verbindung innerhalb des Schaltfeldes verlaufen muß. Es ist jeweils nur erforderlich, daß jede mögliche Position der Betätigung des Schaltfeldes zumindest mit drei Sensoren geradlinig verbunden werden kann, wobei diese geradlinige Verbindung sich innerhalb des Schaltfeldes befindet.

Gemäß einer bevorzugten Ausführungsform der Berührungsschalteinrichtung weist die Steuereinrichtung Konfigurationsmittel zur Bestimmung der Zuordnungsfunktion zwischen Positionen der Betätigung und zugeordneter Schaltfläche auf. Dabei kann es sich beispielsweise bei den Konfigurationsmitteln um eine Anzahl von Schaltern, beispielsweise sog. Dip-Schaltern handeln, wodurch eine in einer Speichereinrichtung der Steuereinrichtung abgelegte Konfiguration ausgewählt wird. Eine Vielzahl von jeweils fest vorgegebenen Konfigurationen der Zuordnungsfunktion ist dabei in der Speichereinrichtung der Steuereinrichtung abgelegt. Über solche Schalter kann zum Beispiel leicht eingestellt werden, ob ein bestimmter elektrischer Verbrauch an einer Anschlußstelle angeordnet ist oder nicht. Eine alternative Ausführungsform der Konfigurationsmittel wäre eine Schnittstelle an der Steuereinrichtung, wobei über die Schnittstelle ein Eingabegerät an die Steuereinrichtung anschließbar ist und über die Schnittstelle eine danach feste Konfiguration der Zuordnungsfunktion in einer Speichereinrichtung der Steuereinrichtung abgelegt wird. Dabei kann es sich bei einer Konfiguration nicht alleine um eine einzige, dauerhafte Zuordnungsfunktion handeln; bei einer Konfiguration kann es auch sein, daß abhängig von Zuständen des Systemes, beispielsweise abhängig von vorher erfolgten Betätigungen des Schaltfeldes, unterschiedliche Zuordnungsfunktionen vorgegeben sind. Dabei sind aber die Zuordnungsfunktionen selbst nicht veränderbar. Zur Abspeicherung der Zuordnungsfunktion bzw. der Konfiguration kann insbesondere ein einmal beschreibbarer, dann nicht mehr auslöschbarer Speicher (PROM, EPROM) verwendet werden.

Gemäß einer Ausgestaltung der Erfindung weisen die Konfigurationsmittel eine selbsttätig durchführbare Initialisierungsfunktion auf. Während der Initialisierungsfunktion wird zumindest die Präsenz an steuerbarer elektrischer Verbraucher überprüft. Jedem der präsenten Verbraucher wird dann wenigstens eine Schaltfläche zugeordnet. Das Schaltfeld wird dann entsprechend der Anzahl der anzuordnenden Schaltflächen unterteilt. Dabei ist es durchaus möglich, daß nicht allen Schaltflächen dieselbe Fläche des Schaltfeldes zugewiesen wird. Neben der Überprüfung der reinen Präsenz könnte es auch möglich sein, zusätzlich auch noch weitere Merkmale des Verbrauchers zu erfassen, beispielsweise der Typ einer oder mehrerer möglicherweise anschließbarer Verbraucher. Die Zuweisung von Schaltflächen kann dann nicht nur präsenzabhängig, sondern auch typabhängig erfolgen. Dadurch ist es beispielsweise möglich, daß, wenn ein elektrischer Verbraucher eine Zweiteilung aufweist, wie zum Beispiel bei einer Kochfläche, wo die Kochfläche neben der Hauptheizfläche auch eine zuschaltbare Zusatzheizfläche aufweist, mehrere Schaltflächen für einen Verbraucher vorgesehen sind. Eine Schaltfläche dient dann dem Zu- bzw. dem Abschalten der Zusatzheizfläche, während die andere Schaltfläche der Leistungssteuerung der Hauptheizfläche und, falls die Zusatzheizfläche zugeschaltet ist, auch der Zusatzheizfläche dient. Darüber hinaus ist es noch möglich, daß eine weitere Schaltfläche diesem Verbraucher zugewiesen ist, mittels derer der Verbraucher nochmals getrennt zu- und abschaltbar ist.

Gemäß einer Ausgestaltung der Erfindung ist es vorgesehen, daß das Schaltfeld eine unveränderliche Markierung der Schaltflächen des Schaltfeldes aufweist. Alternativ hierzu ist es möglich, daß im Bereich des Schaltfeldes Anzeigemittel vorgesehen sind, wobei an der betätigbaren Oberfläche eine Markierung der Schaltflächen aufgrund der aktuellen Zuordnungsfunktion vorgenommen wird. Bei den Anzeigemitteln handelt es sich vorzugsweise um einen LCD-Bildschirm. Dabei ist es vorzugsweise so, daß die Oberfläche des Bildschirmes gleichzeitig das Schaltfeld definiert oder bildet.

Gemäß einer Weiterbildung der Erfindung wird die Zuordnungsfunktion in Abhängigkeit vorhergehend vorgenommener Betätigungen des Schaltfeldes bestimmbar. Für diese Fälle ist jeweils eine entsprechende Anzahl unterschiedlicher Zuordnungsfunktionen in der Speichereinrichtung der Steuereinrichtung abgelegt, die dann jeweils aufgerufen werden können. Dabei ist es möglich, daß jeweils ein Satz von Zuordnungsfunktionen in einer Speichereinrichtung abgelegt oder ablegbar ist und durch die Konfigurationsmittel der jeweilige Satz von Zuordnungsfunktionen auswählbar bzw. festlegbar oder bestimmbar ist.

Gemäß einer weiterführenden Ausgestaltung der Erfindung sind die Schaltflächen in Abhängigkeit von der zugeordneten Schaltfunktion vorzugsweise piktogrammartig ausgebildet und/oder markiert.

Weiter vorteilhaft ist eine Ausgestaltung, bei der das Sensorsignal der Sensoren den Abstand zwischen der Position der Betätigung und dem jeweiligen Sensor repräsentiert, wobei in der Steuereinrichtung aufgrund des jeweiligen Abstandes zu mehreren Sensoren die Position der Betätigung ermittelt wird. Weiter vorteilhaft ist es, wenn das Schaltfeld in dem Bereich der Kochmulde eines wenigstens einen Herd beinhaltenden Küchengerätes angeordnet ist. Besonders vorteilhaft ist es dabei, wenn es sich bei dem Herd um einen Glaskeramikherd handelt, wobei im Bereich der Kochmulde die Oberfläche des Herdes von einer Glaskermikplatte gebildet wird. Im Bereich dieser Glaskeramikplatte wird ein vorzugsweise transparent ausgebildetes Schaltfeld angeordnet. Dabei bildet die Glaskeramikplatte die Betätigungsfläche des Schaltfeldes. Dabei sind insbesondere Anzeigemittel unterhalb des Schaltfeldes angeordnet und erzeugen beispielsweise über ein aufprojiziertes Bild an der Glaskeramikfläche die Markierungen der Schaltflächen. Eine weiterführende Ausgestaltung der Erfindung ist darin zu sehen, daß die Schaltfunktion, die einer Schaltfläche zugeordnet ist, den Betrieb oder die Leistungsaufnahme eines elektrischen Verbrauchers, insbesondere eines elektrischen Heizelementes, das vorzugsweise einer Kochplatte zugeordnet ist, betrifft.

Im übrigen ist die Erfindung anhand der Zeichnung näher erläutert, dabei zeigt:
- Fig. 1: die schematische Darstellung einer erfindungsgemäßen Berührungsschalteinrichtung,
- Fig. 2: die schematische Darstellung der Anordnung der Betätigungsfläche im Bereich eines Kochfeldes, und
- Fig. 3: die schematische Darstellung der Bestimmung der Position der Betätigung im Schaltfeld aufgrund der Messung des Abstandes der Position zum Sensor durch den jeweiligen Sensor.

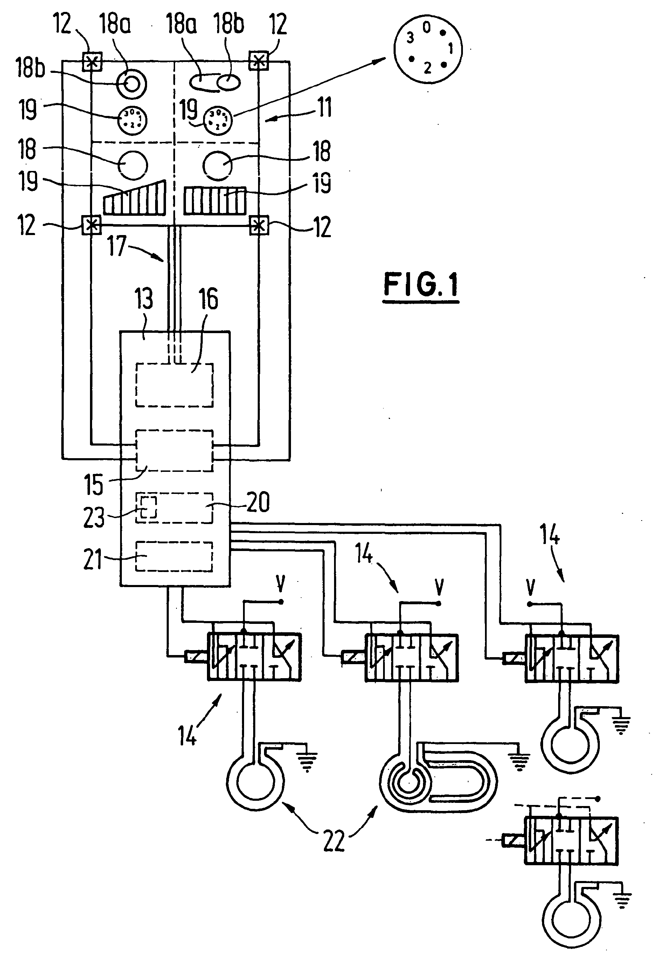

Die Fig. 1 zeigt in schematischer Darstellung eine erfindungsgemäße Berührungsschalteinrichtung. Die Berührungsschalteinrichtung besteht aus dem Schaltfeld 11 mit den Sensoren 12, der Steuereinrichtung 13 und den von der Steuereinrichtung 13 angesteuerten Schaltelementen 14. Dabei untergliedert sich die Steuereinrichtung 13 in eine Erfassung und Auswerteeinheit 15, in der aus den empfangenen Sensorsignalen die Position der Betätigung des Schaltfeldes 11 aus den über die Sensoren 12 erfaßten Signale ermittelt wird. Ferner kann eine Anzeigesteuerung 16 vorgesehen sein, die mit dem Datenbus 17 mit dem Schaltfeld 11 verbunden ist, wobei es sich bei dem Schaltfeld um einen LCD-Bildschirm handeln kann, der zugleich als Schaltfeld ausgebildet ist und bei dem über die Anzeigesteuereinheit 16 die Markierung der Schaltflächen 18, 19 im Bereich des Schaltfeldes für den Benutzer sichtbar markiert wird. Ferner weist die Steuereinrichtung 13 eine Zuordnungseinheit 20 auf, in der sowohl die Zuordnung von Position der Betätigung zu Schaltfläche als auch die Zuordnung von Schaltfläche zu Schaltfunktion vorgenommen wird. Aufgrund der als durchzuführend ermittelten Schaltfunktion wird von der Zuordnungseinheit 20 ein Signal an die Leistungsstufe 21 der Steuereinrichtung 13 abgegeben. Angesteuert von der Leistungsstufe 21 werden unterschiedliche Schaltstellungen der Schaltelemente 14 erzeugt.

Das Schaltfeld kann beispielsweise aus einem LCD-Bildschirm gebildet sein. Alternativ könnte es auch in seiner Oberfläche als Bereich der Glaskeramikplatte eines Herdes ausgebildet sein, an dessen Unterseite entsprechende Sensorelemente angeordnet sind. Dabei kann es sich bei dem Schaltfeld sowohl um eine nach einem kapazitiven oder aber nach einem resistiv arbeitenden Schaltelement handeln, das sensitiv hinsichtlich einer von außen erfolgenden Berührung des Schaltfeldes arbeitet. Gemäß dem dargestellten Beispiel ist das Schaltfeld 11 rechteckig ausgebildet und an jeder der vier Ecken des Schaltfeldes ist ein Sensor angeordnet. Es würde zur eindeutigen Bestimmung der Position der Betätigung des Schaltfeldes 11 auch ausreichen, drei Sensoren 12 vorzusehen, die beispielsweise in Dreiecksform innerhalb der Fläche des Schaltfeldes 11 anordenbar wären, um eine eindeutige Bestimmung der Position der Betätigung durchzuführen. Die Erhöhung der Anzahl der Sensoren 12 auf insgesamt vier erhöht zwar den Rechenaufwand bei der Bestimmung der Position der Betätigung, verbessert aber die Meßgenauigkeit und auch die Auflösung der Berührungsschalteinrichtung.

Bei dem dargestellten Schaltfeld 11 kann es sich sowohl um ein Schaltfeld, das als LCD-Bildschirm ausgebildet ist, als auch um ein Schaltfeld handeln, das andere Anzeigemittel aufweist. Beispielsweise ist es auch möglich, daß die Oberfläche des Schaltfeldes aus der Glaskeramikplatte eines Glaskeramikkochfeldes gebildet wird. Dabei ist an der Unterseite der Glaskeramikplatte, die sich herdinnenseitig befindet, also auf der Seite, wo auch die Heizelemente angeordnet sind, eine Sensoreinrichtung angebracht ist. Diese Sensoreinrichtung besteht beispielsweise aus einer Anzahl von transparenten Schichten, die auf der Unterseite der Glaskeramikplatte im Bereich des Schaltfeldes 11 aufgebracht sind und die ihre kapazitiven oder resistiven Eigenschaften aufgrund einer Berührung der Glaskeramikplatte an ihrer Oberfläche in diesem Bereich verändern. Dabei kann es erforderlich sein, daß eine bestimmte Betätigungskraft auf die Oberfläche der Glaskeramikfläche aufgebracht wird. Über die entsprechende Anzahl von Sensoren wird der jeweilige Abstand der Position der Betätigung zu dem entsprechenden Sensor 12 ermittelt. Dabei sind entsprechende, auch transparent ausgebildete Berührungsschalter bekannt. Viele von ihnen arbeiten nach dem kapazitiven oder resistiven Arbeitsprinzip. Es sind auch andere Arbeitsprinzipien, beispielsweise die Verwendung eines Signalgebers und eines Signalempfängers und der Auswertung der Signallaufzeit oder des empfangenen Signalbildes (insbesondere optisch, akustisch oder elektromagnetisch) arbeitende Berührungssensoren bekannt, die bei der Erfindung ebenfalls Verwendung finden können.

In der dargestellten Ausführungsform ist die Berührungsschalteinrichtung für die Verwendung bei einem Herd bestimmt. Dabei ist das Schaltfeld 11 entsprechend der an diesem angenommenen Herd vorhandenen vier Kochfelder 22 in vier Gruppen von Schaltflächen 18, 19 unterteilt. Dabei ist jede Gruppe von Schaltflächen 18, 19 einer Kochstelle zugeordnet. Die Gruppen von Schaltflächen 18, 19 sind dabei auf dem Schaltfeld 11 so angeordnet und den als elektrischen Verbrauchern fungierenden Heizeinrichtungen der Kochstellen 22 zugeordnet, daß die Anordnung der Kochstellen im Kochfeld des Herdes der Anordnung der Gruppen von Schaltflächen im Schaltfeld entspricht. Die Fläche einer Gruppe von Schaltflächen auf dem Schaltfeld 11 kann dabei in Abhängigkeit der Größe der einzelnen Kochflächen, beispielsweise proportional dazu, bestimmt werden.

Dabei ist es im dargestellten Fall so, daß es Bereiche des Schaltfeldes 11 gibt, denen keine Schaltfläche zugeordnet ist und denen somit auch keine Schaltfunktion zugeordnet ist. Jedes der Gruppen von Schaltflächen 18, 19 besteht im dargestellten Beispiel aus zwei Elementen. Es ist eine Schaltfläche 18 vorhanden, die unter Umständen in zwei Schaltflächen 18a und 18b unterteilt ist und einer Schaltfläche 19. Die Schaltfläche 19 ist dabei jeweils zur Bestimmung der Heizleistung an einer Kochstelle 22 vorgesehen. Bei den Schaltflächen 19 kann es sich beispielsweise um symbolisierte Drehknebel mit unterschiedlichen Schaltstufen handeln, wobei jede Schaltstufe für sich genommen eine Schaltfläche bildet. Durch Betätigung der entsprechenden Schaltfläche mit der entsprechenden Leistungsmarkierung (Leistungsstufen 1 bis 6) wird die entsprechende Heizleistung ausgewählt. Alternativ ist es auch möglich, die Schaltfläche 19 dadurch piktogrammartig zu symbolisieren, daß ein Band dargestellt ist, wobei die Auswahl einzelner Elemente des Bandes möglich ist und so ein Schubschalter fingiert wird. Der Schubschalter kann durch Ziehen auf eine entsprechende Position eines Segmentes des Schubschalters in seiner Leistung ausgewählt werden. Ein so realisierter Schubschalter oder Drehknebel ist dabei im Sinne dieser Anmeldung als eine Schaltfläche anzusehen, obgleich noch unterschiedliche Positionen der Betätigung realisiert werden.

Die Schaltfläche 18, bzw. wo vorhanden, die beiden Schaltflächen 18a, 18b dienen der Ein/Aus-Schaltfunktion. Über diese Funktion kann in einfacher Weise die zugeordnete Heizeinrichtung der entsprechenden Kochstelle ein- bzw. ausgeschaltet werden. So kann es beispielsweise aus Sicherheitsgründen erforderlich sein, zum Einschalten einer Heizeinrichtung gleichzeitig sowohl die Schaltfläche 18 oder 18a und die zugehörige Schaltfläche 19 zum Einstellen der Heizleistung zu betätigen. Dadurch wird verhindert, daß durch versehentliches Berühren der Schaltfläche an einer Stelle ein Einschalten einer Kochstelle erfolgt, was, wenn es unbeabsichtigt geschieht, nachteilig ist. Des weiteren ist, wo notwendig, eine Schaltfläche 18a und 18b ausgebildet, wobei die Schaltfläche 18a einem Nebenheizelement und die Schaltfläche 18b dem Hauptheizelement einer Kochstelle zugeordnet ist. Es sind Kochstellen bekannt, bei denen neben einer Hauptheizstelle zusätzlich auch noch eine Nebenheizstelle betrieben werden kann, wobei die Nebenheizstelle nur dann einschaltbar ist, wenn die Hauptheizstelle in Betrieb ist. Die Nebenheizstelle wird dabei mit der gleichen Leistung versorgt wie die Hauptheizstelle. Deshalb ist es nicht erforderlich, für die Nebenheizstelle eine getrennte Leistungsregelschaltung vorzusehen und daher ist auch hierfür keine getrennte Schaltfläche notwendig. Durch Betätigen der Schaltfläche 18a kann nun die entsprechende Nebenheizstelle zugeschaltet werden. Entweder durch erneutes Betätigen der Schaltfläche 18a oder aber durch Betätigen der Schatfläche 18b kann der Betrieb der Nebenheizzone wieder eingestellt werden, so daß nur noch das Hauptheizelement der entsprechenden Kochstelle in Betrieb ist.

Die Zuordnung zwischen der Position der Betätigung des Schaltfeldes 11 und der entsprechenden Schaltfläche wird über die Zuordnungseinheit 20 durchgeführt. Die Zuordnungseinheit 20 kann dabei auch die Anzeigesteuereinheit 16 beeinflussen, so daß die Anzeigemittel des Schaltfeldes 11 abhängig vom Betriebszustand angesteuert werden können. Zur Vornahme der Anpassung der Steuereinheit 13 an die dieser zugeordneten Verbraucher 22 ist das Konfigurationsmittel 23, das im ausgewählten Beispiel Teil der Zuordnungseinheit 20 ist, vorgesehen. Bei dem Konfigurationsmittel 23 kann es sich zum Beispiel um eine Serie von Dip-Schaltern handeln, wobei beispielsweise für jede Kochstelle zwei Dip-Schalter vorgesehen sind. Mit dem ersten der beiden Dip-Schalter kann die Präsenz eines elektrischen Verbrauchers an dem Anschluß für die Leistungssteuerung signalisiert werden, während über die Stellung des zweiten Dip-Schalters das Vorhandensein eines Nebenverbrauchers eingestellt werden kann. So ist es möglich, die gleiche Steuereinheit für unterschiedliche Kochstellen zu verwenden, wobei sich die Kochstellen in der Anzahl der elektrischen Verbraucher, also der Kochplatten, unterscheiden können. Der Unterschied der Kochstellen kann aber auch darin liegen, daß eine unterschiedliche Anzahl von Nebenverbrauchern vorhanden ist. Dabei erfolgt die Aufteilung des Schaltfeldes 11 in Schaltflächen 18, 18, 18b und 19 in Abhängigkeit der am Konfigurationsmittel 23 eingestellten Konfiguration.

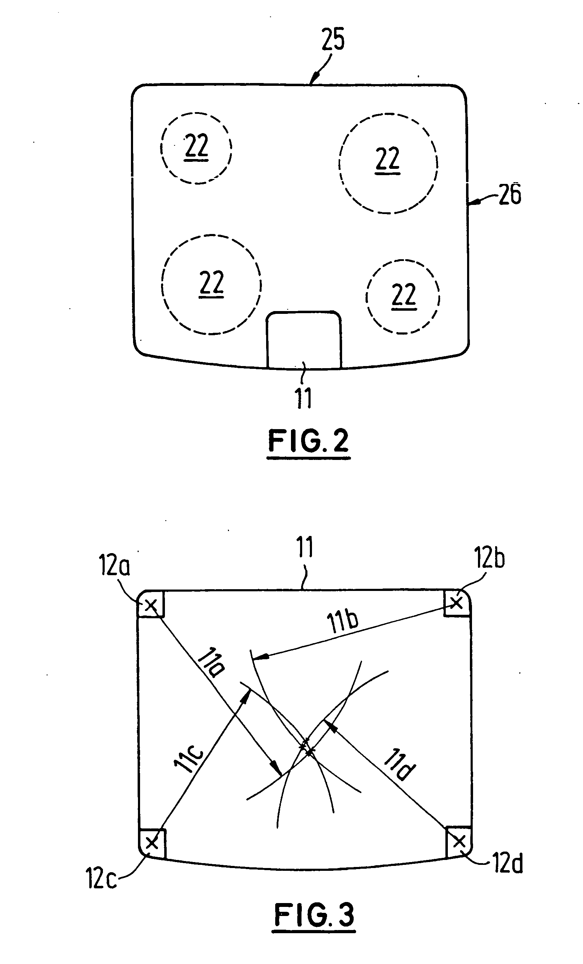

Die Fig. 2 zeigt in beispielhafter schematischer Darstellung die Ausbildung eines Kochfeldes mit mehreren Kochstellen 22. Das Kochfeld 25 weist dabei als Abschluß nach oben die Glaskeramikplatte 26 auf. In einem Bereich der Glaskeramikplatte ist das Schaltfeld 11 ausgebildet. Das Schaltfeld 11 ist also Teil des Kochfeldes 25.

Die Fig. 3 zeigt in schematischer Darstellung die Bestimmung der Position der Betätigung durch Triangularisation in der Auswerteeinheit 15. An den vier Ecken des Schaltfeldes 11 sind die Sensoren 12a, 12b, 12c, 12d angeordnet. Beim Betätigen des Schaltfeldes 11 wird in jedem der vier Sensoren 12a, 12b, 12c, 12d das Sensorsignal verändert. Die Veränderung des Sensorsignals ist charakteristisch und abhänbgig vom Abstand des Betätigungsortes zum Sensor. Es handelt sich dabei in der Regel um die Änderung eines Spannungswertes oder eines Stromwertes, wobei die Sensortechnik entweder kapazitiv oder resistiv arbeitet. Jedem Spannungswert kann ein Abstandswert Ua, Ub, Uc, Ud zugeordnet werden. Rechnerisch wird nun der Schnittpunkt der vier Kreise ermittelt, die den jeweiligen Sensor 12a, 12b, 12c, 12d mit einem Radius von jeweils einer Strecke Ua, Ub, Uc, Ud umgeben. Bei einer meßfehlerfreien Messung müßten sich die vier Kreise in genau einem Punkt schneiden. Da alle Signale von einer Meßungenauigkeit und eventuellen Störungen behaftet sind, wird nicht ein gemeinsamer Schnittpunkt zu ermitteln sein. Vielmehr werden mehrere Schnittpunkte zu ermitteln sein und aus diesen Schnittpunkten kann dann die Mitte ermittelt werden, also der Ort, an dem die Betätigung wohl erfolgt ist. Auf diese Weise wird jeder Betätigung des Schaltfeldes 11 genau eine Position zugeordnet. Aus dieser Position heraus läßt sich ermitteln, ob sie in einem der Schaltfelder 18, 18a, 18b, 19 liegt. Ist dies der Fall, wird bei dem zugeordneten elektrischen Verbraucher die der Betätigung des Schaltfeldes zugeordnete Schaltfunktion ausgeführt, beispielsweise das Zu- oder Abschalten eines Nebenheizelementes oder aber eine Erhöhung oder Verringerung der Heizleistung im Heizelement selbst.

## Patentansprüche

1. Berührungsschalteinrichtung, insbesondere für Küchengeräte wie Herde, Backöfen und dergleichen, mit einem Schaltfeld (11), das wenigstens eine Schaltfläche (18, 18a, 18b, 19) aufweist, wobei in einer Steuereinrichtung (13) eine Zuordnung zwischen Schaltfläche (18, 18a, 18b, 19) und bei Betätigung der Schaltfläche (18, 18a, 18b, 19) auszuführender Schaltfunktion vorgesehen ist, mit wenigstens einem Sensor (12, 12a, 12b, 12c, 12d) zum Erfassen der Betätigung der wenigstens einen Schaltfläche (18, 18a, 18b, 19) aufgrund der Veränderung des Sensor signals, wobei die Sensorsignale mehrerer Sensoren (12, 12a, 12b, 12c, 12d) in der Steuereinrichtung (13) ausgewertet werden, wobei in der Steuereinrichtung (13) eine Zuordnungsfunktion zwischen Position und Schaltfläche (18, 18a, 18b, 19) derart vorgegeben ist, daß die Schaltfunktion durchgeführt wird, die der Schaltfläche (18, 18a, 18b, 19) zugeordnet ist, welche mittels der Zuordnungsfunktion der Position der Betätigung zugewiesen ist, **dadurch gekennzeichnet, daß** aus den Veränderunggen der Sensorsignale der verschiedenen Sensoren bei einer Betätigung im Schaltfeld (11) die Position des Betätigungsortes im Schaltfeld (11) ermittelt wird.

2. Berührungsschalteinrichtung nach Anspruch 1, **dadurch gekennzeichnet, daß** die Anzahl der Sensoren (12, 12a, 12b, 12c, 12d) so gewählt ist, daß eine eindeutige Bestimmung der Position der Betätigung möglich ist, wozu die Anzahl der Sensoren wenigstens drei und vorzugsweise höchstens sechs beträgt.

3. Berührungsschalteinrichtung nach Anspruch 1 oder 2, **dadurch gekennzeichnet, daß** die Steuereinrichtung (13) Konfigurationsmittel (23) zur Bestimmung der Zuordnungsfunktion zwischen Position der Betätigung und Schaltfläche (18, 18a, 18b, 19) aufweist.

4. Berührungsschalteinrichtung nach Anspruch 3, **dadurch gekennzeichnet, daß** die Konfigurationsmittel (23) eine vorzugsweise selbsttätig durchführbare Initialisierungsfunktion aufweist, wobei während der Durchführung der Initialisierungsfunktion zumindest die Präsenz ansteuerbarer elektrischer Verbraucher überprüft und jedem Verbraucher wenigstens eine Schaltfläche zugeordnet wird.

5. Berührungsschalteinrichtung nach einem der Ansprüche 3 oder 4, **dadurch gekennzeichnet, daß** das Schaltfeld eine unveränderliche Markierung der Schaltfläche aufweist.

6. Berührungsschalteinrichtung nach einem der Ansprüche 3 bis 5, **dadurch gekennzeichnet, daß** das Schaltfeld an seiner betätigbaren Oberfläche sichtbare Anzeigemittel aufweist, insbesondere von einem Bildschirm, vorzugsweise einem LCD-Bildschirm, gebildet wird, wobei eine Markierung der Schaltflächen aufgrund der aktuellen Zuordnungsfunktion vorgesehen ist.

7. Berührungsschalteinrichtung nach einem der Ansprüche 3 bis 6, **dadurch gekennzeichnet, daß** die Zuordnungsfunktion in Abhängigkeit vorgenommener Betätigungen des Schaltfeldes (11) bestimmbar ist.

8. Berührungsschalteinrichtung nach einem der vorstehenden Ansprüche, **dadurch gekennzeichnet, daß** die Schaltflächen (18, 18a, 18b, 19) in Abhängigkeit von der zugeordneten S chaltfunktion vorzugsweise piktogrammartig ausgebildet sind.

9. Berührungsschalteinrichtung nach einem der vorstehenden Ansprüche, **dadurch gekennzeichnet, daß** das Sensorsignal den Abstand zwischen Position der Betätigung und jeweiligem Sensor (12, 12a, 12b, 12c, 12d) repräsentiert, wobei in der Steuereinrichtung aufgrund des jeweiligen Abstandes zu mehreren Sensoren die Position der Betätigung ermittelt wird.

10. Berührungsschalteinrichtung nach einem der vorstehenden Ansprüche, **dadurch gekennzeichnet, daß** das Schaltfeld (11) im Bereich der Kochmulde (25) eines wenigstens einen Herd beinhaltenden Küchengerätes angeordnet ist, wobei das Schaltfeld (11) im Bereich einer Glaskeramikplatte (26) des Herdes angeordnet ist.

11. Berührungsschalteinrichtung nach einem der vorstehenden Ansprüche, **dadurch gekennzeichnet, daß** die Schaltfunktion den Betrieb oder die Leistungsaufnahme eines elektrischen Verbrauchers (22) insbesondere elektrischer Heizelemente betrifft.

## Claims

1. Contact switching device, particularly for kitchen appliances such as cookers, ovens, etc., having a switch panel (11) provided with at least one switching surface (18, 18a, 18b, 19) and where in a control device (13) there is an assignment between switching surface (18, 18a, 18b, 19) and the switching function to be implemented on operating said switching surface (18, 18a, 18b, 19), with at least one sensor (12, 12a, 12b, 12c, 12d) for detecting the operation of the at least one switching surface (18, 18a, 18b, 19) on the basis of a change to the sensor signal, the sensor signals of several sensors (12, 12a, 12b, 12c, 12d) being evaluated in the control device (13) and where in said control device (13) an assignment function between the position and switching surface (18, 18a, 18b, 19) is preset in such a way that the switching function assigned to the switching surface (18, 18a, 18b, 19) is performed and which is allocated by means of the assignment function to the operating position, **characterized in that** from the changes to the sensor signals of the different sensors during an operation in the switch panel (11), the position of the operating location in said switch panel (11) is determined.

2. Contact switching device according to claim 1, **characterized in that** the number of sensors (12, 12a, 12b, 12c, 12d) is chosen in such a way that a clear determination of the operating position is possible and for this purpose the number of sensors is at least three and preferably a maximum of six.

3. Contact switching device according to claim 1 or 2, **characterized in that** the control device (13) has configuring means (23) for determining the assignment function between the operating position and the switching surface (18, 18a, 18b, 19).

4. Contact switching device according to claim 3, **characterized in that** the configuring means (23) have a preferably automatically performable initializing function and during the performance of the initializing function at least the presence of controllable electric loads is checked and with each load is assigned at least one switching surface.

5. Contact switching device according to one of the claims 3 or 4, **characterized in that** the switch panel has an invariable marking of the switching surface.

6. Contact switching device according to one of the claims 3 to 5, **characterized in that** on an operable surface the switch panel has visible display means, particularly being formed by a screen, preferably a LCD screen, a marking of the switching surfaces being provided on the basis of the current assignment function.

7. Contact switching device according to one of the claims 3 to 6, **characterized in that** the assignment function can be determined as a function of performed operations of the switch panel (11).

8. Contact switching device according to one of the preceding claims, **characterized in that** the switching surfaces (18, 18a, 18b, 19) are constructed preferably in pictogram-like manner as a function of the assigned switching function.

9. Contact switching device according to one of the preceding claims, **characterized in that** the sensor signal represents the distance between the operating position and the given sensor (12, 12a, 12b, 12c, 12d) and the operating position is determined in the control device on the basis of the given spacing from several sensors.

10. Contact switching device according to one of the preceding claims, **characterized in that** the switch panel (11) is located in the vicinity of the hob (25) of a kitchen appliance incorporating at least one cooker, the switch panel (11) being positioned in the vicinity of a glass ceramic hotplate (26) of said cooker.

11. Contact switching device according to one of the preceding claims, **characterized in that** the switching function relates to the operation or the power consumption of an electric load (22), particularly electric heating elements.

## Revendications

1. Dispositif de commutation à effleurement, notamment pour des appareils de cuisine comme des cuisinières, des fours ou similaires, avec une zone de commande (11) qui présente au moins une surface de commande (18, 18a, 18b, 19), sachant que dans le dispositif de commande (13) on prévoit une affectation entre une surface de commande (18, 18a, 18b, 19) et, quand la surface de commande (18, 18a, 18b, 19) est actionnée, la fonction de commande qui est à effectuer, avec au moins un détecteur (12, 12a, 12b, 12c, 12d) pour détecter l'actionnement de la ou des surfaces de commande (18, 18a, 18b, 19) par le changement du signal de détecteur, sachant que les signaux de détecteur de plusieurs détecteurs (12, 12a, 12b, 12c, 12d) sont évalués dans le dispositif de commande (13), sachant que dans le dispositif de commande (13) une fonction d'affectation entre une position et une surface de commande (18, 18a, 18b, 19) est prédéterminée de manière à ce que l'opération de commutation attribuée à la surface de commande (18, 18a, 18b, 19) associée à la position de l'actionnement au moyen de la fonction d'affectation soit effectuée, **caractérisé en ce que** la position de l'endroit de l'actionnement dans la zone de commande (11) soit évaluée au cas d'un actionnement dans la zone de commande (11) par les changements des signaux de détecteur des différents détecteurs.

2. Dispositif de commutation à effleurement d'après la revendication 1, **caractérisé en ce que** le nombre de détecteurs (12, 12a, 12b, 12c, 12d) est choisi de manière à pouvoir évaluer de manière univoque la position de l'actionnement, sachant que le nombre de détecteurs s'élève au moins à trois et de préférence au plus à six.

3. Dispositif de commutation à effleurement d'après la revendication 1 ou 2, **caractérisé en ce que** le dispositif de commande (13) présente des dispositifs de configuration (23) pour définir la fonction d'affectation entre la position de l'actionnement et la surface de commande (18, 18a, 18b, 19).

4. Dispositif de commutation à effleurement d'après la revendication 3, **caractérisé en ce que** les dispositifs de configuration (23) présentent une fonction d'initialisation qui peut être effectuée de manière préférablement automatique, sachant que pendant l'exécution de la fonction d'initialisation on vérifie au moins la présence de récepteurs à commande électrique et qu'on affecte à chaque récepteur au moins une surface de commande.

5. Dispositif de commutation à effleurement d'après une des revendications 3 ou 4, **caractérisé en ce que** la zone de commande présente un marquage invariable de la surface de commande.

6. Dispositif de commutation à effleurement d'après une des revendications de 3 à 5, **caractérisé en ce que** la zone de commande présente à sa surface actionnable des dispositifs d'affichage visibles, qu'elle est constituée notamment d'un écran, de préférence d'un écran à cristaux liquides, sachant qu'on prévoit un marquage des surfaces de commande conformément à la fonction d'affectation actuelle.

7. Dispositif de commutation à effleurement d'après une des revendications de 3 à 6, **caractérisé en ce que** la fonction d'affectation peut être définie en fonction des actionnements effectués dans la zone de commande (11).

8. Dispositif de commutation à effleurement d'après une des revendications précédentes, **caractérisé en ce que** les surfaces de commande (18, 18a, 18b, 19) sont réalisées de préférence à la manière de pictogrammes, en fonction de la fonction de commutation qui leur est affectée.

9. Dispositif de commutation à effleurement d'après une des revendications précédentes, **caractérisé en ce que** le signal de détecteur représente l'écart entre la position de l'actionnement et le détecteur (12, 12a, 12b, 12c, 12d) respectif, sachant que la position de l'actionnement est évaluée dans le dispositif de commande en vertu de son écart respectif par rapport à plusieurs détecteurs.

10. Dispositif de commutation à effleurement d'après une des revendications précédentes, **caractérisé en ce que** la zone de commande (11) est disposée dans le champ du plan de cuisson (25) d'un appareil de cuisine comprenant au moins une cuisinière, sachant que la zone de commande (11) est disposée dans le champ d'une plaque en vitrocéramique (26) de la cuisinière.

11. Dispositif de commutation à effleurement d'après une des revendications précédentes, **caractérisé en ce que** la fonction de commutation concerne le service ou la puissance absorbée par un consommateur de puissance électrique (22) et notamment par des éléments de chauffage électrique.
